(19) Europäisches Patentamt
European Patent Office
Office européen des brevets

(11) **EP 1 380 849 B1**

(12) **EUROPÄISCHE PATENTSCHRIFT**

(45) Veröffentlichungstag und Bekanntmachung des Hinweises auf die Patenterteilung:
**19.12.2007 Patentblatt 2007/51**

(51) Int Cl.:
***G01R 31/36*** *(2006.01)*

(21) Anmeldenummer: **03014790.4**

(22) Anmeldetag: **28.06.2003**

(54) **Verfahren zur Ermittlung der entnehmbaren Ladungsmenge einer Speicherbatterie und Überwachungseinrichtung**

Process for the determination of the available charge quantity of a storage battery and monitoring device

Procédé pour la détermination d'état de charge d'une batterie de stockage et dispositif de surveillance

(84) Benannte Vertragsstaaten:
**DE ES FR GB IT**

(30) Priorität: **13.07.2002 DE 10231700**

(43) Veröffentlichungstag der Anmeldung:
**14.01.2004 Patentblatt 2004/03**

(73) Patentinhaber: **VB Autobatterie GmbH & Co. KGaA**
**30419 Hannover (DE)**

(72) Erfinder: **Koch, Ingo, Dipl.-Ing.**
**31789 Hameln (DE)**

(74) Vertreter: **Gerstein, Hans Joachim et al**
**Gramm, Lins & Partner**
**Theodor-Heuss-Strasse 1**
**38122 Braunschweig (DE)**

(56) Entgegenhaltungen:
**EP-A- 1 167 987      DE-A- 10 049 495**
**DE-A- 19 950 424**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Ermittlung der im Vollladezustand entnehmbaren Ladungsmenge einer Speicherbatteriebezogen auf den Neuzustand durch Messung von Batteriestromwerten und Batteriespannungswerten zu mindestens zwei Zeitpunkten vor oder während einer Anstiegsphase sowie während oder nach einer Abklingphase eines Lade- oder Entladevorgangs.

Die Erfindung betrifft weiterhin eine Überwachungseinrichtung für eine Speicherbatterie mit Messmitteln zur Messung von Batteriespannungswerten und Batteriestromwerten und mit Auswertemitteln.

Für die Bestimmung und Vorhersage des Zustands einer Speicherbatterie mit einfachen Mitteln während des Betriebs der Speicherbatterie sind zahlreiche Verfahren bekannt.

Beispielsweise ist in der DE 199 50 424 A1 ein Verfahren zur Bestimmung der Startfähigkeit einer Starterbatterie eines Kraftfahrzeugs beschrieben, bei dem der Batteriestrom und die Batteriespannung kurz vor und während einer Belastung der Starterbatterie durch Start des Verbrennungsmotors ermittelt wird. Aus den jeweiligen Wertepaaren des Batteriestromes und der Batteriespannung werden der Innenwiderstand und die entnommene Ladungsmenge berechnet. Aus der Anstiegsrate des Innenwiderstands über der entnommenen Ladungsmenge wird ein Maß für die Verfügbarkeit der Starterbatterie beim Startvorgang abgeleitet.

In der DE 37 12 629 C2 ist eine Messvorrichtung zur Bestimmung der verbleibenden Lebensdauer einer Kraftfahrzeugbatterie beschrieben, welche die Batteriespannung und den dazugehörigen Laststromwert vor und nach dem erstmaligen Starten bei vollgeladenem Zustand der Speicherbatterie erfasst. Zudem wird der temperaturkompensierte Innenwiderstand ermittelt und in einem Speicher abgelegt. Dieser anfängliche temperaturkompensierte Innenwiderstand wird mit Innenwiderstandswerten verglichen, die bei

späteren Startvorgängen der Verbrennungskraftmaschine durch die Kraftfahrzeugbatterie ermittelt werden. Die Anzeige der voraussichtlichen Lebensdauer der Speicherbatterie erfolgt danach in Abhängigkeit von vorgegebenen abgespeicherten Schwellwerten.

Aus der WO 99/17128 ist bekannt, beim Startvorgang die Spannungswerte benachbarter Spannungsminima zu vergleichen, die aufgrund der Kompression und Dekompression der Motorkolben einer mit Hilfe der Speicherbatterie gestarteten Verbrennungskraftmaschine auftreten. Der Unterschied zwischen diesen Werten dient als Maß für eine Anzeige des Batteriezustandes.

In der DE 39 01 680 C2 ist ein Verfahren zur Überwachung der Kaltstartfähigkeit einer Starterbatterie eines Verbrennungsmotors beschrieben, bei dem während des Startvorgangs der zeitliche Verlauf des Spannungsabfalls an den Anschlussklemmen des Anlassers für den Verbrennungsmotor beobachtet und ausgewertet wird.

In der DE 198 47 648 A1 ist ein Verfahren zur Bestimmung des Ladezustands und der Hochstrombelastbarkeit von Speicherbatterien offenbart, bei dem die Leerlaufspannung ermittelt, die echten Ruhespannungen unter Berücksichtigung insbesondere des zeitlichen Verlaufs ermittelt, die umgesetzte Strommenge ermittelt und die Säurekapazität ermittelt wird. Hieraus wird eine Aussage über die Startfähigkeit der Speicherbatterie abgeleitet.

In der WO 00/04620 ist ein System und ein Verfahren zur Beobachtung des Zustands einer Speicherbatterie beschrieben, das in einem Fahrzeug installiert ist. Es wird aus den während des Motorstarts ermittelten Batteriespannungs- und Batteriestromwerten ein Batterieinnenwiderstand und ein Polarisationswiderstand errechnet. Zusätzlich wird ein Wert für den Ladezustand SOC bestimmt. Aus diesen Werten und deren Anstiegsraten wird der Batteriezustand analysiert und eine Aussage getroffen, ob die Batterie den Motor noch starten kann.

In der DE 100 49 495 A1 ist ein Verfahren zur Bestimmung der Gebrauchsfähigkeit eines Akkumulators beschrieben, bei dem durch Messung der Akkumulatorenspannung beim Startvorgang eine zeitlich darauf folgende Ruhespannung zu dem Zeitpunkt bestimmt wird, bei dem der direkt folgende Nulldurchgang des durch den Akkumulator fließenden Stroms stattfindet. Aus der Spannungsdifferenz wird ein Innenwiderstand als Maß für die Gebrauchsfähigkeit ermittelt.

Aus der EP 1 167 987 A1 ist bekannt, eine Temperaturkompensation bei der Bestimmung von Batteriekenngrößen durchzuführen.

Die vorstehend beschriebenen Verfahren und Vorrichtungen dienen zwar dazu, die Eignung eine Speicherbatterie hinsichtlich der Fähigkeit zu bestimmen, einen Motor zu starten oder den Ladezustand einer neuwertigen Batterie zu ermitteln. Eine Aussage über die entnehmbare Ladungsmenge der Speicherbatterie, insbesondere bei kleinen Strömen, kann hiermit aber nicht getroffen werden.

Das Problem bei Speicherbatterien ist jedoch, dass die bei vollgeladener Speicherbatterie entnehmbare Ladungsmenge Q durch verschiedene Ursachen abnehmen kann. Einer gebrauchten Speicherbatterie kann somit nicht mehr die gleiche Ladungsmenge entnommen werden wie im Neuzustand. Diese Ursachen können z. B. bei Bleiakkumulatoren der Verlust an aktiver Masse durch Abschlammen, Sulfatation oder ähnliches sein.

Wird z. B. der Ladezustand einer Speicherbatterie durch Messung der Ruhespannung ermittelt, wie dies z. B. bei einem Bleiakkumulator möglich ist, so kann mit diesem Wert keine Aussage darüber getroffen werden, welche Ladungsmenge der Speicherbatterie noch entnommen werden kann, wenn diese nicht mehr im Neuzustand ist. Der Grund hierfür ist, dass zwar in diesem Fall der Ladezustand ein Maß für die der Säure entnehmbare Ladungsmenge ist, die Ladungsmenge, die der aktiven Masse noch entnommen werden kann, korrelliert jedoch nur im Neuzustand mit der Ladungsmenge in der Säure.

Bei einer Definition des Ladezustands SOC als Quotient der Differenz zwischen Nennladungsmenge und entnommener Ladungsmenge zur Nennladungsmenge.

$$SOC = \frac{(Nennladungsmenge - entnommener\ Ladungsmenge)}{Nennladungsmenge}$$

gibt der Ladezustand SOC ebenfalls keine richtige Aussage über die entnehmbare Ladungsmenge Q der Speicherbatterie.

Der Ladezustand nach diesen Definitionen gibt somit keine Aussage über die entnehmbare Ladungsmenge Q im Vollladezustand. Da bei vielen technischen Anwendungen der Ladezustand SOC nur durch diese Methoden ermittelt werden kann, besteht der Bedarf nach einem Verfahren, das die tatsächlich entnehmbare Ladungsmenge Q bestimmt.

DE 100 49 495 A1 offenbart ein Verfahren zur Bestimmung der Gebrauchsfähigkeit eines Akkumulators durch Messung der Akkumulatorenspannung beim Startvorgang. Es wird die Klemmenspannung vor dem Start, die kleinste Spannung während des Starts und die Batteriespannung zum Zeitpunkt des ersten Stromnulldurchgangs gemessen. Die Differenz zwischen der Klemmenspannung vor dem Start und der Batteriespannung zum Zeitpunkt des ersten Stromdurchgangs wird berechnet und zur Überprüfung benutzt, ob der Einfluss des Starts auf den Ladezustand zu groß ist. Für den Fall, dass der Einfluss des Starts auf den Ladezustand zu groß ist, wird die Messung verworfen. Weiterhin wird die Neigung des Spannungsanstiegs als Maß für den Innenwiderstand der Batterie bestimmt. Es wird somit die Spannungsdifferenz zwischen der nach der Abklingphase eines Startvorgangs bestimmten Batteriespannung beim Stromnulldurchgang, d. h. im stromlosen Zustand, und der Einbruchsspannung, bei der der größte Spannungseinbruch während des Startvorgangs erfolgt, zur Bestimmung der Gebrauchsfähigkeit eines Akkumulators bewertet. Der tatsächliche Ladezustand und damit die der Speicherbatterie noch entnehmbare Ladungsmenge soll aus der Ruhespannung, d. h. der Batteriespannung vor einer Belastung oder weit nach Ende der Abklingphase einer Belastung bestimmbar sein. Damit kann allerdings keine Aussage darüber getroffen werden, welche Ladungsmenge der Speicherbatterie noch entnommen werden kann, wenn diese nicht mehr im Neuzustand ist.

EP 1 167 987 A1 offenbart die Lehre einer Temperaturkompensation bei der Bestimmung von Batteriekenngrößen.

Aufgabe der Erfindung war es daher, ein Verfahren zur Ermittlung der im Vollladezustand entnehmbaren Ladungsmenge Q einer Speicherbatterie bezogen auf den Neuzustand durch Messung von Batteriestromwerten und Batteriespannungswerten zu mindestens zwei Zeitpunkten vor oder während einer Anstiegsphase und während einer Abklingphase eines Lade- oder Entladevorgangs zu schaffen, mit dem durch einfache Messung eine Kenngröße H für die entnehmbare Ladungsmenge Q einer nicht mehr im Neuzustand befindlichen Speicherbatterie bestimmt werden kann.

Die Aufgabe wird mit dem gattungsgemäßen Verfahren erfindungsgemäß gelöst durch Bestimmen einer Kenngröße H für die entnehmbare Ladungsmenge Q aus der Beziehung von mindestens einem Batteriespannungswert aus der Anstiegsphase zu mindestens einem Batteriespannungswert aus der Abklingphase bei annährend gleichem Batteriestromwert oder aus der Beziehung von mindestens einem Batteriestromwert aus der Anstiegsphase zu mindestens einem Batteriestromwert aus der Abklingphase bei annährend gleichem Batteriespannungswert.

Es wird daher vorgeschlagen, das Verhalten der Hysterese auszuwerten, die sich durch Auftragen der Batteriestromwerte und Batteriespannungswerte bei einer vorzugsweise kurzzeitigen pulsförmigen Belastung in Lade- oder Entladerichtung ergibt, und hieraus auf die entnehmbare Ladungsmenge Q der Speicherbatterie zu schließen.

Hierzu werden vorzugsweise die Batteriestromwerte und Batteriespannungswerte an mindestens zwei Zeitpunkten gleichzeitig ermittelt. Es hat sich gezeigt, dass die Beziehung der Batteriestromwerte bei annähernd gleichem Batteriespannungswert und auch die Beziehung der Batteriespannungswerte bei annähernd gleichem Batteriestromwert ein Maß für die entnehmbare Ladungsmenge Q ist. Die gleichen Batteriespannungswerte bzw. Batteriestromwerte in der Hysteresekurve ergeben sich durch das Zeitverhalten während der Belastung, indem mindestens eine erste Messung kurz vor der Belastung oder während der Anstiegsphase der Belastung und eine zweite Messung in der Abklingphase während des Abklingens der Belastung oder kurz nach der Belastung durchgeführt wird.

Die Beziehung zur Bestimmung der Kenngröße H kann beispielsweise die Differenz von zwei zu unterschiedlichen Zeitpunkten ermittelten BatterieSpannungen sein, wobei zu den beiden Zeitpunkten die Batterieströme annähernd gleich sind. Die Beziehung kann aber auch die Differenz von zwei zu unterschiedlichen Zeitpunkten ermittelten Batterieströmen bei annähernd identischen Batteriespannungen sein.

Es hat sich aber auch gezeigt, dass die Kenngröße H für die noch entnehmbare Ladungsmenge Q aus der Beziehung des Verhältnisses der in einem ersten Zeitpunkt vor oder während einer Anstiegsphase der Belastung ermittelten Batteriespannung zu der in einem zweiten Zeitpunkt nach oder während einer Abklingphase der Belastung ermittelten Batteriespannung bestimmt werden kann. Wiederum sollten zu dem ersten und zweiten Zeitpunkt die Batterieströme annähernd gleich sein. Gleichermaßen kann die Beziehung auch das Verhältnis der an einem ersten und zweiten Zeitpunkt ermittelten Batterieströme sein, wobei die Batteriespannungen annähernd gleich sind.

Erfindungswesentlich ist dabei, dass die Hysteresekurve derart ausgewertet wird, dass ein Zahlenwert für eine der Messgrößen, d. h. Batteriestrom oder Batteriespannung, festgelegt wird und die beiden zugehörigen Wertepaare der jeweils anderen Messgröße, d. h. Batteriespannung oder Batteriestrom, aus der Hysteresekurve ermittelt und zueinander in Beziehung gesetzt werden.

Darüber hinaus kann es aus technischen Gründen sinnvoll sein, jeweils getrennt für die Anstiegsphase und die Abklingphase einen Zahlenwert für den Bätteriestrom oder die Batteriespannung festzulegen. Die dann bei unterschiedlichen festgelegten Zahlenwerten gewonnenen Wertepaare der anderen Meßgröße können dann in analoger Weise zueinander in Beziehung gesetzt werden. Dieses Vorgehen gilt insbesondere bei einem linearen Verlauf der Hysteresekurve.

Die Batteriespannungswerte bzw. Batteriestromwerte während der Anstiegs- und Abklingphase können auch durch Auswertung des Hystereseverhaltens zueinander in Beziehung gesetzt werden. Hierzu können beispielsweise intelligente Verfahren, wie neuronale Netze sowie Fuzzy-Techniken eingesetzt werden, die z. B. anhand von bestimmten Punkten der Hysteresekurve eine Aussage über die entnehmbare Ladungsmenge Q treffen können. Besonders vorteilhaft ist es, die Kenngröße H aus Parametern eines Ersatzschaltbildes oder eines anderen Modells abzuleiten, das an die Hysteresekurve angepasst ist.

Für eine beispielsweise in einem Kraftfahrzeug eingesetzte Speicherbatterie ist es vorteilhaft, wenn die gewählten Zeitpunkte in der Startphase eines mit der Speicherbatterie gekoppelten Verbrennungsmotors liegen.

Es ist auch denkbar, die Batteriespannungswerte miteinander in Beziehung zu setzen, die sich ergeben, wenn der Batteriestrom zu den gewählten Zeitpunkten annähernd Null ist.

Zur Durchführung des Verfahrens kann ein Batteriespannungswert oder ein Batteriestromwert festgelegt werden und durch kontinuierliche Überwachung die zugehörige andere Messgröße, das heißt des Batteriestromes oder der Batteriespannung, ermittelt werden, wenn der festgelegte Wert der Batteriespannung oder des Batteriestromes erreicht wird.

Alternativ hierzu kann auch ein kontinuierliches Aufnehmen und Abspeichern der Batteriestromwerte und Batteriespannungswerte als Hysteresekurven während einer Belastung erfolgen. Die abgespeicherten Hysteresekurven werden zur Bestimmung der Kenngröße H später ausgewertet. Da die Messwerte unter Umständen in Zeitintervallen abgetastet werden, ist es vorteilhaft, eine Interpolation, Extrapolation und/oder Regression der ermittelten Batteriespannungswerte und Batteriestromwerte vorzunehmen, um Batteriespannungen bei vorgegebenen Batterieströmen oder Batterieströme bei vorgegebenen Batteriespannungen hochgenau zu bestimmen. Diese Verfahren können aber auch zum Ausgleich möglicher Messfehler eingesetzt werden.

Der Vorhersagewert für die entnehmbare Ladungsmenge Q aus der Kenngröße H kann durch Bestimmung des Ladezustandes SOC der Speicherbatterie und/oder der Batterietemperatur und dergleichen verbessert werden, indem der Kennwert H durch die ermittelten Zusatzfaktoren, wie Ladezustand SOC, Batterietemperatur etc. korrigiert wird.

Hierzu ist es vorteilhaft, Kennfelder Hlern für Kennwerte einer Speicherbatterie im Neuzustand in Abhängigkeit von dem Ladezustand SOC und den Batterietemperaturen zu erlernen und abzuspeichern. Die entnehmbaren Ladungsmenge Q werden dann aus der ermittelten Kenngröße $H_m$ bei einem momentanen Ladezustand $SOC_m$ und einer momentanen Batterietemperatur $TBat_m$ mit einer entsprechenden Neuwert-Kenngröße $H_{neu}$ bestimmt, die aus dem Kennfeld HLern für den momentanen Ladezustand $SOC_m$ und die momentane Batterietemperatur $TBat_m$ ermittelt wird.

Besonders vorteilhaft ist es, eine Maßzahl J beispielsweise als Differenz oder Verhältnis von der ermittelten Kenngröße $H_m$ und der entsprechenden Kenngröße $H_{neu}$ im Neuzustand bei dem momentanen Ladezustand $SOC_m$ und der momentanen Batterietemperatur $TBat_m$ zu berechnen. Die entnehmbare Ladungsmenge Q wird dann mit einem Kennfeld für entnehmbare Ladungsmengenwerte bestimmt, wobei in dem Kennfeld entnehmbare Ladungsmengenwerte in Abhängigkeit von den Ladezuständen SOC, der Batterietemperatur TBat und den Maßzahlen J abgespeichert sind.

Die entnehmbare Ladungsmenge Q ist nach dem oben genannten Verfahren in der Regel nicht bei extrem kurzen und niedrigen Belastungen sowie Langzeitbelastungen mit ausreichender Genauigkeit zu bestimmen. Der Zeitraum zwischen den Zeitpunkten der in Beziehung gesetzten Batteriespannungswerte oder Batteriestromwerte sollte daher einen definierten Minimalzeitraum überschreiten und einen definierten Maximalzeitraum unterschreiten, das heißt innerhalb eines definierten Zeitfensters liegen.

Die Aufgabe wird weiterhin durch die gattungsgemäße Überwachungseinrichtung dadurch gelöst, dass die Auswertemittel zur Durchführung des oben beschriebenen Verfahrens ausgebildet sind.

Die Erfindung wird nachfolgend anhand der beigefügten Zeichnungen näher erläutert. Es zeigen:

Figur 1 - Ausschnitt eines Batteriestromverlaufs für einen typischen Start eines Verbrennungsmotors mit einer Speicherbatterie;

Figur 2 - Hysteresekurve mit einer über den Batteriestrom aufgetragenen Batteriespannung für zwei unterschiedliche gealterte Speicherbatterien gleichen Typs;

Figur 3.- Diagramm zur Bestimmung der verfügbaren Ladungsmenge aus der Kenngröße H bei unterschiedlichen Batterietemperaturen;

Figur 4 - Diagramm zur Bestimmung der verfügbaren Ladungsmenge aus der Kenngröße H bei unterschiedlichen Ladezuständen SOC.

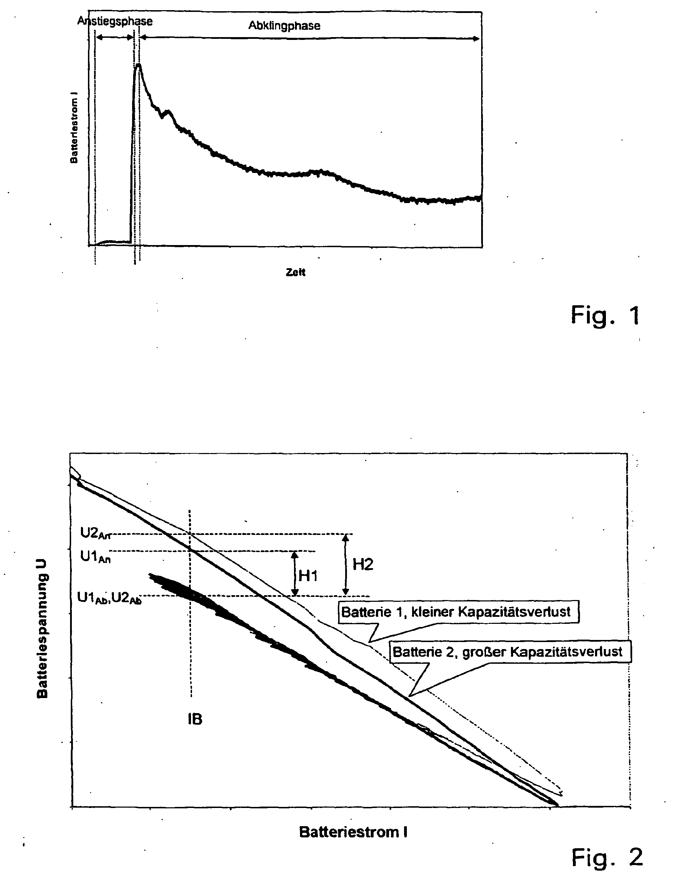

Die Figur 1 lässt einen Ausschnitt eines Batteriestromverlaufs für einen typischen Start eines Verbrennungsmotors erkennen. Es wird deutlich, dass der Batteriestrom in einem relativ kurzem Zeitraum ein Strommaximum erreicht. Anschließend klingt der Batteriestrom langsam ab. Der Zeitraum bis zum Erreichen des Strommaximums wird als Anstiegsphase An und der Zeitraum nach dem Strommaximum als Abklingphase Ab definiert.

Die Erfindung beruht hiervon ausgehend auf der Erkenntnis, dass die entnehmbare Ladungsmenge Q aus einer Kenngröße H bestimmt werden kann, die als Beziehung von Batteriespannungswerten $U_{An}$ oder Batteriestromwerten $I_{An}$ in der Anstiegsphase An zu den entsprechenden Werten $U_{Ab}$, $I_{Ab}$ in der Abklingphase Ab definiert wird.

Dies wird im Folgenden näher erläutert.

Die Figur 2 zeigt eine Hysteresekurve für zwei typische willkürlich gewählte und unterschiedlich gealterte Speicherbatterien gleichen Typs mit einem gleichen Ladezustand SOC bei einer gleichen Batterietemperatur TBat. Die Hysteresekurve ist also als die über den Batteriestrom IB aufgetragene Batteriespannung UB definiert. Die beiden ausgewählten Speicherbatterien haben lediglich unterschiedlich entnehmbare Ladungsmengen Q.

Zur Bestimmung der Ladungsmengen Q wird bei einem festgelegten Batteriestrom IB die Batteriespannung $U_{Ab}$ in der Anstiegsphase An und Abklingphase Ab ermittelt und die beiden Batteriespannungen $U_{An}$ und $U_{Ab}$ in eine Beziehung gesetzt. Hieraus ergibt sich die kleinere Kenngröße H1 für die erste Speicherbatterie mit kleinem Kapazitätsverlust und die größere Kenngröße H2 für die zweite Speicherbatterie mit großem Kapazitätsverlust.

Es wird aus der Hysteresekurve unmittelbar deutlich, dass die Kenngröße H beispielsweise aus der Differenz der Batteriespannung $U_{An}$ in der Anstiegsphase An und der Batteriespannung $U_{Ab}$ in der Abklingphase Ab bestimmt werden kann. Gleichermaßen kann aber auch das Verhältnis zwischen der Batteriespannung $U_{An}$ in der Anstiegsphase An zu der Batteriespannung $U_{Ab}$ in der Abklingphase Ab berechnet werden.

Aus dem Vergleich der Hysteresekurven wird auch deutlich, dass der Spannungseinbruch und damit der Innenwiderstand kein Maß für die noch entnehmbare Ladungsmenge Q der Speicherbatterie ist. Obwohl die Speicherbatterie 1 einen kleineren Kapazitätsverlust erlitten hat, zeigt sie einen größeren ßeren maximalen Spannungseinbruch als die Speicherbatterie 2 mit größerem Kapazitätsverlust.

Vielmehr wird bei dem erfindungsgemäßen Verfahren vorgeschlagen, die Kenngröße H beispielsweise nach den Formeln

$$H = U_{An} - U_{Ab} \text{ oder } H = U_{An} : U_{Ab}$$

zu bestimmen, wobei der Batteriestromwert IB festgelegt ist. Die Batteriespannungswerte $U_{An}$ und $U_{Ab}$ in der Anstiegsphase An und in der Abklingphase Ab sind die entsprechenden Werte der Hysteresekurve bei dem festgelegten Stromwert IB.

In einer alternativen Ausführungsform des Verfahrens kann die Kenngröße H auch aus der Beziehung von zwei Batteriestromwerten $I_{An}$, $I_{Ab}$ bei identischer Batteriespannung UB bestimmt werden.

Für den Fall, dass für den festgelegten Stromwert IB keine zugehörigen Spannungswerte oder den festgelegten Spannungswert UB keine zugehörigen Stromwerte ermittelt wurden, können die Batteriespannungs- und Batteriestromwerte auch durch Interpolation, Extrapolation oder Regression ermittelt werden. Diese Verfahren können aber auch zur Beseitigung von Messungenauigkeiten angewendet werden, wenn Messwerte für den festgelegten Batteriestromwert IB oder Batteriespannungswert UB existieren.

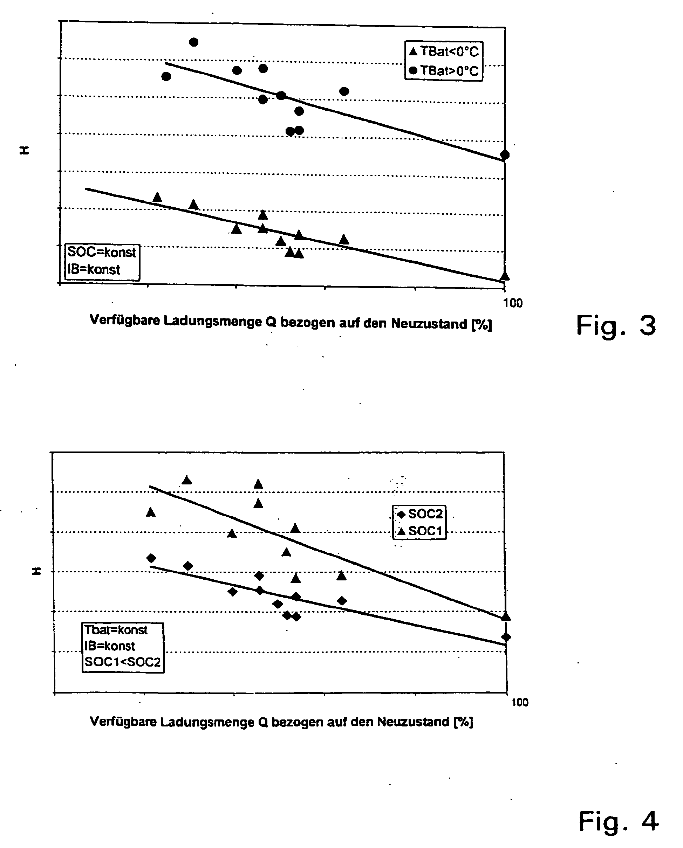

Die Figur 3 zeigt ein Diagramm in Abhängigkeit von der verfügbaren Ladungsmenge Q, wobei in einem Fall die Batterietemperatur TBat <0°C (Dreiecke) und in dem anderen Fall die Batterietemperatur Tbat >0°C (Kreise) ist. Der Ladezustand SOC und der Batteriestromwert IB zur Bestimmung der Kenngröße H sind hierbei konstant. Jeder Punkt repräsentiert eine bestimmte Batterie mit jeweils unterschiedlicher Alterung.

Ebenso zeigt die Figur 4 ein Diagramm aus dem die Abhängigkeit zwischen der Kenngröße H und der entnehmbaren Ladungsmenge Q bei zwei unterschiedlichen Ladungsmengen SOC1 und SOC2 erkennbar ist, wobei die Batterietemperatur TBat und der Batteriestrom IB zur Bestimmung der Kenngröße H konstant ist. Der Ladungszustand SOC1 ist hierbei kleiner als der Landungszustand SOC2 (SOC1 < SOC2).

Es wird deutlich, dass ein eindeutiger und in diesem Fall sogar linearer Zusammenhang zwischen der Kenngröße H und der entnehmbaren Ladungsmenge Q bezogen auf den Neuzustand besteht. Auf Grund dieses Zusammenhangs ist es möglich, dass die entnehmbare Ladungsmenge Q direkt in Abhängigkeit von der Kenngröße H bestimmt werden kann.

Dabei wird vorteilhafter Weise eine Korrektur des Kennwertes H durch den Ladezustand SOC und/oder der Batterietemperatur TBat vorgenommen. Diese Korrektur kann beispielsweise durch empirisches oder mathematisches Aufnehmen von Kennfeldern oder mathematischen Funktionen vorgenommen werden. Die Abhängigkeit zwischen der entnehmbaren Ladungsmenge Q und der Kenngröße H in Abhängigkeit von dem Ladezustand SOC oder der Batterietemperatur TBat kann beispielsweise durch Simulationsrechnungen mathematisch ermittelt werden, aber auch ermittelt werden.

Die Kenngröße H kann in Abhängigkeit von dem Ladezustand SOC und der Batterietemperatur TBat für eine Speicherbatterie im Neuzustand auch vorteilhaft durch intelligente Signalverarbeitung erlernt werden. Bei dem Lernvorgang wird dann z. B. ein Kennfeld HLern in Abhängigkeit von dem Ladezustand SOC und der Batterietemperatur TBat erzeugt. Wenn die Speicherbatterie nicht mehr im Neuzustand ist, wird später eine ermittelte Kenngrößen $H_m$ bei einem Ladezustand $SOC_m$ und einer beliebigen Batterietemperatur $TBat_m$ mit der erlernten Kennzahl $H_{neu}$ im Neuzustand verglichen, die anhand des Ladezustands $SOC_m$ und der Batterietemperatur $TBat_m$ z. B. aus dem gelernten Kennfeld HLern ermittelt wird. Das Ergebnis dieses Vergleichs ist eine Maßzahl J, die beispielsweise die Differenz oder das Verhältnis von $H_m$ und $H_{neu}$ sein kann

$$J \; = \; H_m \; - \; H_{neu} \; \text{oder} \; J \; = \; H_m : H_{neu}.$$

Diese Maßzahl J ergibt dann zusammen mit den Werten des Ladezustands $SOC_m$ und der Batterietemperatur $TBat_m$ und z. B. einem Kennfeld für Kenngrößen Q in Abhängigkeit von dem Ladezustand SOC, der Batterietemperatur TBat und der Maßzahl J die entnehmbare Ladungsmenge Q der Speicherbatterie.

**Patentansprüche**

1.  Verfahren zur Ermittlung der im Vollladezustand entnehmbaren Ladungsmenge (Q) einer Speicherbatterie bezogen auf den Neuzustand (3) durch Messung von Batterieströmen (I) und/oder Batteriespannungen (U) zu mindestens zwei Zeitpunkten (t) vor oder während einer Anstiegsphase sowie während einer Abklingphase eines Lade- oder Entladevorgangs, **durch** Bestimmen einer Kenngröße (H) für die entnehmbare Ladungsmenge (Q) aus der Beziehung von mindestens einem Batteriespannungswert (U) aus der Anstiegsphase zu mindestens einem Batteriespannungswert (U) aus der Abklingphase bei annährend gleichem Batteriestromwert oder aus der Beziehung von mindestens einem Batteriestromwert (I) aus der Anstiegsphase zu mindestens einem Batteriestromwert (I) aus der Abklingphase bei annährend gleichem Batteriespannungswert.
    wobei das Verhalten der Hysterese ausgewentet wird, die sich durch Auftragen der Batteriestromwerte (I) und Batteriespannungswerte (U) bei einer vorzugsweise kurzzeitigen pulsförmigen Belastung in Lade- oder Entladerichtung ergibt, um hieraus auf die entnehmbare Ladungsmenge (Q) der Speicherbatterie (3) zu schließen.

2.  Verfahren nach Anspruch 1, **dadurch gekennzeichnet, dass** die Beziehung die Differenz von zwei zu unterschiedlichen Zeitpunkten (t) ermittelten Batteriespannungen (U) ist, wobei zu den beiden Zeitpunkten (t) die Batterieströme (I) annähernd gleich sind.

3.  Verfahren nach Anspruch 1, **dadurch gekennzeichnet, dass** die Beziehung die Differenz von zwei zu unterschiedlichen Zeitpunkten (t) ermittelten Batterieströmen (1) ist, wobei zu den beiden Zeitpunkten (t) die Batteriespannungen (U) annäherend gleich sind.

4.  Verfahren nach Anspruche 1, **dadurch gekennzeichnet, dass** die Beziehung das Verhältnis der an einem ersten Zeitpunkt ($t_1$) vor oder während der Anstiegsphase der Belastung ermittelten Batteriespannung ($U_1$) zu der in einem zweiten Zeitpunkt ($t_2$) nach oder während der Abklingphase ermittelten Batteriespannung ($U_2$) ist, wobei zu dem

**6**

ersten und zweiten Zeitpunkt ($t_1$, $t_2$) die Batterieströme ($I_1$, $I_2$) annähernd gleich sind.

5. Verfahren nach Anspruche 1, **dadurch gekennzeichnet, dass** die Beziehung das Verhältnis der an einem ersten Zeitpunkt ($t_1$) vor oder während der Anstiegsphase ermittelten Batteriestroms ($I_1$) zu der an einem zweiten Zeitpunkt ($t_2$) nach oder während der Abklingphase ermittelten Batteriestroms ($I_2$) ist, wobei zu dem ersten und zweiten Zeitpunkt die Batteriespannungen ($U_1$, $U_2$) annähernd gleich sind.

6. Verfahren nach einem der vorhergehenden Ansprüche, **dadurch gekennzeichnet, dass** die gewählten Zeitpunkte (t) in der Phase des Startens eines mit der Speicherbatterie gekoppelten Verbrennungsmotors liegen.

7. Verfahren nach einem der vorhergehenden Ansprüche, **dadurch gekennzeichnet, dass** der Batteriestrom zu den gewählten Zeitpunkten annähernd Null ist.

8. Verfahren nach einem der vorhergehenden Ansprüche, **gekennzeichnet durch** kontinuierliches Aufnehmen und Abspeichern der Batteriestromwerte (I) und Batteriespannungswerte (U) als Hysteresekurven während einer Belastung und späteres Auswerten der abgespeicherten Hysteresekurven zur Bestimmung der Kenngröße (H) für die noch entnehmbare Ladungsmenge (Q).

9. Verfahren nach einem der vorhergehenden Ansprüche, **gekennzeichnet durch** Interpolation und/oder Extrapolation von ermittelten Batteriespannungswerten (U) und Batteriestromwerten (I) zur Ermittlung von Batteriespannungen (U) bei vorgegebenen Batterieströmen (I) oder zur Ermittlung von Batterieströmen (I) bei vorgegebenen Batteriespannungen (U).

10. Verfahren nach einem der vorhergehenden Ansprüche, **gekennzeichnet durch** Bestimmung des Ladezustandes (SOC) der Speicherbatterie und/oder der Batterietemperatur (TBat) und Korrektur der Kenngröße (H) **durch** den Ladezustand (SOC) und/oder die Batterietemperatur (TBat).

11. Verfahren nach einem der vorhergehenden Ansprüche, **gekennzeichnet durch** Korrektur der Kenngröße (H) **durch** die über einen definierten Zeitraum entnommene Ladungskapazität.

12. Verfahren nach einem der vorhergehenden Ansprüche, **dadurch gekennzeichnet, dass** die Bestimmung der Kenngröße (H) erfolgt, wenn der Zeitraum zwischen den Zeitpunkten (t) der in Beziehung gesetzten Batteriespannungswerten (U) oder Batteriestromwerten (I) einen definierten Minimalzeitraum überschreitet und einen definierten Maximalzeitraum unterschreitet.

13. Verfahren nach einem der vorhergehenden Ansprüche, **gekennzeichnet durch** Vergleichen der Kenngröße (H) mit vorgegebenen Kennfeldern für entnehmbare Ladungsmengen (Q) in Abhängigkeit der Ladungszustände (SOC), Batterietemperaturen (TBat) und Kenngrößen (H).

14. Verfahren nach Anspruch 13, **gekennzeichnet durch** Erlernen und Abspeichern von Kennfeldern (HLern) für Kenngrößen (H) einer Speicherbatterie im Neuzustand in Abhängigkeit von dem Ladezustand (SOC) und den Batterietemperaturen (TBat) und Bestimmen der entnehmbaren Ladungsmenge (Q) aus der ermittelten Kenngröße (H) bei einem momentanen Ladezustand ($SOC_m$) und einer momentanen Batterietemperatur ($TBat_m$) mit einer entsprechenden Nennwert-Kenngröße ($H_{neu}$), die aus dem Kennfeld (HLern) für den momentanen Ladezustand ($SOC_m$) und die momentane Batterietemperatur ($Tbat_m$) ermittelt wird.

15. Verfahren nach Anspruch 14, **gekennzeichnet durch** Berechnen einer Maßzahl (J) als Differenz oder Verhältnis von der ermittelten Kenngröße ($H_m$) und der entsprechenden Kenngröße ($H_{neu}$) im Neuzustand bei dem momentanen Ladezustand ($SOC_m$) und der momentanen Batterietemperatur ($TBat_m$) und Bestimmen der entnehmbaren Ladungsmenge (Q) mit einem Kennfeld für entnehmbare Ladungsmengenwerte (Q), die in Abhängigkeit von Ladezuständen (SOC), Batterietemperatur (TBat) und Maßzahlen (J) in dem Kennfeld abgespeichert sind.

16. Verfahren nach einem der vorhergehenden Ansprüche, **gekennzeichnet durch** Bestimmen der Kenngröße (H) aus Parametern eines Ersatzschaltbildes oder Modells, wobei die Parameter **durch** Anpassung des Ersatzschaltbildes oder Modells an die ermittelten Batteriestromwerte (I) und/oder Batteriespannungswerte (U) in der Anstiegs- und Abklingphase ermittelt werden.

17. Überwachungseinrichtung für eine Speicherbatterie mit Messmitteln zur Messung von Batteriespannungswerten (U) und Batteriestromwerten (I), und mit Auswertemitteln, **dadurch gekennzeichnet, dass** die Auswertemittel zur Durchführung des Verfahrens nach einem der vorhergehenden Ansprüche ausgebildet sind.

**Claims**

1.  Method for determining the amount of charge (Q) which can be drawn from a storage battery (3) with respect to the new state by measuring battery currents (I) and/or battery voltages (U) at at least two points in time (t) before or during a rise phase and during or after a decay phase of a charging or discharging operation, by determining a characteristic variable (H) for the amount of charge (Q) which can be drawn from the relationship of at least one battery voltage value (U) from the rise phase with respect to at least one battery voltage value (U) from the decay phase or from the relationship of at least one battery current value (I) from the rise phase with respect to at least one battery current value (I) from the decay phase, wherein the behavior of the hysteresis which is obtained by plotting the battery current values (I) and battery voltage (U) for preferably brief pulse-like loading in the charging or discharging direction is evaluated to conclude from this the amount of charge Q which can be drawn from the storage battery (3).

2.  Method according to claim 1, **characterized in that** the relationship is the difference between two battery voltages (U) determined at different points in time (t), the battery currents (I) being approximately the same at the two points in time (t).

3.  Method according to claim 1, **characterized in that** the relationship is the difference between two battery currents (I) determined at different points in time (t), the battery voltages (U) being approximately the same at the two points in time (t).

4.  Method according to claim 1, **characterized in that** the relationship is the ratio of the battery voltage ($U_1$) determined at a first point in time ($t_1$) before or during the rise phase of the loading with respect to the battery voltage ($U_2$) determined at a second point in time ($t_2$) after or during the decay phase, the battery currents ($I_1$, $I_2$) being approximately the same at the first and second points in time ($t_1$, $t_2$).

5.  Method according to claim 1, **characterized in that** the relationship is the ratio of the battery current ($I_1$) determined at a first point in time ($t_1$) before or during the rise phase with respect to the battery current ($I_2$) determined at a second point in time ($t_2$) after or during the decay phase, the battery voltages ($U_1$, $U_2$) being approximately the same at the first and second points in time.

6.  Method according to one of the preceding claims, **characterized in that** the chosen points in time (t) lie in the phase of starting an internal combustion engine coupled to the storage battery.

7.  Method according to one of the preceding claims, **characterized in that** the battery current at the chosen points in time is approximately zero.

8.  Method according to one of the preceding claims, **characterized by** continuous recording and storing of the battery current values (I) and battery voltage values (U) as hysteresis curves during loading and later evaluation of the stored hysteresis curves for the determination of the characteristic variable (H) for the amount of charge (Q) which can still be drawn.

9.  Method according to one of the preceding claims, **characterized by** interpolation and/or extrapolation of determined battery voltage values (U) and battery current values (I) for the determination of battery voltages (U) for given battery currents (I) or for the determination of battery currents (I) for given battery voltages (U).

10. Method according to one of the preceding claims, **characterized by** determination of the state of charge (SOC) of the storage battery and/or of the battery temperature (TBat) and correction of the characteristic variable (H) by the state of charge (SOC) and/or the battery temperature (TBat).

11. Method according to one of the preceding claims, **characterized by** correction of the characteristic variable (H) by the charge capacity drawn over a defined time period.

12. Method according to one of the preceding claims, **characterized in that** the determination of the characteristic variable (H) takes place when the time period between the points in time (t) of the battery voltage values (U) or battery current values (I) set in relation is above a defined minimum time period and is below a defined maximum time period.

13. Method according to one of the preceding claims, **characterized by** comparing the characteristic variable (H) with given families of characteristics for amounts of charge (Q) which can be drawn in dependence on the states of charge (SOC), battery temperatures (TBat) and characteristic variables (H).

14. Method according to claim 13, **characterized by** learning and storing families of characteristics (HLern) for characteristic variables (H) of a storage battery in the new state in dependence on the state of charge (SOC) and the battery temperatures (TBat) and determining the amount of charge (Q) which can be drawn from the determined characteristic variable (H) for a momentary state of charge ($SOC_m$) and a momentary battery temperature ($TBat_m$) with a corresponding nominal value characteristic variable ($H_{new}$), which is determined from the family of characteristics (HLern) for the momentary state of charge ($SOC_m$) and the momentary battery temperature ($Tbat_m$).

15. Method according to claim 14, **characterized by** calculating a coefficient of measure (J) as a difference between or ratio of the determined characteristic variable ($H_m$) and the corresponding characteristic variable ($H_{new}$) in the new state for the momentary state of charge ($SOC_m$) and the momentary battery temperature ($TBat_m$) and determining the amount of charge (Q) which can be drawn with a family of characteristics for values of the amount of charge (Q) which can be drawn, which are stored in the family of characteristics in dependence on states of charge (SOC), battery temperature (TBat) and coefficients of measure (J).

16. Method according to one of the preceding claims, **characterized by** determining the characteristic variable (H) from parameters of an equivalent circuit or model, the parameters being determined by adaptation of the equivalent circuit or model to the determined battery current values (I) and/or battery voltage values (U) in the rise phase and decay phase.

17. Monitoring device for a storage battery with measuring means for measuring battery voltage values (U) and battery current values (I), and with evaluation means, **characterized in that** the evaluation means are designed for carrying out the method according to one of the preceding claims.


**Revendications**

1. Procédé de détermination de la quantité de charge prélevable (Q) à l'état de pleine charge d'une batterie d'accumulateur (3) par rapport à l'état neuf, par mesure de courants de la batterie (I) et/ou de tensions de la batterie (U) à au moins deux instants (t) avant ou pendant une phase d'élévation ainsi que pendant une phase de diminution d'une opération de charge ou de décharge, par détermination d'une grandeur caractéristique (H) pour la quantité de charge prélevable (Q) à partir de la relation entre au moins une valeur de tension de la batterie (U) provenant de la phase d'élévation et au moins une valeur de tension de la batterie (U) provenant de la phase de diminution pour une valeur de courant de la batterie approximativement égale, ou à partir de la relation entre au moins une valeur de courant de la batterie (I) provenant de la phase d'élévation et au moins une valeur de courant de la batterie (I) provenant de la phase de diminution, par une valeur de tension de la batterie approximativement égale, pour on évalue le comportement de l'hystérésis qui se produit par application des valeurs de courant de la batterie (I) et des valeurs de tension de la batterie (U) pendant une sollicitation en forme d'impulsion de préférence de courte durée dans la direction de charge ou de décharge, afin d'en conclure la quantité de charge prélevable (Q) de la batterie d'accumulateur (3).

2. Procédé selon la revendication 1,
   **caractérisé en ce que**
   la relation est la différence de deux tensions de la batterie (U) déterminées à des instants (t) différents, les courants de la batterie (I) étant approximativement égaux aux deux instants (t).

3. Procédé selon la revendication 1,
   **caractérisé en ce que**
   la relation est la différence de deux courants de la batterie (I) déterminés à des instants (t) différents, les tensions de la batterie (U) étant approximativement égales aux deux instants (t).

**4.** Procédé selon la revendication 1,
**caractérisé en ce que**
la relation est le rapport de la tension de la batterie ($U_1$) déterminée à un premier instant ($t_1$), avant ou pendant la phase d'élévation de la sollicitation, à la tension de la batterie ($U_2$) déterminée à un deuxième instant ($t_2$), avant ou pendant la phase de diminution, les courants de la batterie ($I_1$, $I_2$) au premier et au deuxième instants ($t_1$, $t_2$) étant approximativement égaux.

**5.** Procédé selon la revendication 1,
**caractérisé en ce que**
la relation est le rapport du courant de la batterie ($I_1$) déterminé à un premier instant ($t_1$), avant ou pendant la phase d'élévation, au courant de la batterie ($I_2$) déterminé à un deuxième instant ($t_2$) avant ou pendant la phase de diminution, les tensions de la batterie ($U_1$, $U_2$) étant approximativement égales au premier et au deuxième instants.

**6.** Procédé selon l'une des revendications précédentes,
**caractérisé en ce que**
les instants (t) choisis se situent dans la phase de démarrage d'un moteur à combustion couplé à une batterie d'accumulateur.

**7.** Procédé selon l'une des revendications précédentes,
**caractérisé en ce que**
le courant de la batterie est approximativement zéro aux instants choisis.

**8.** Procédé selon l'une des revendications précédentes,
**caractérisé par**
la saisie et l'enregistrement continus des valeurs de courant de la batterie (I) et des valeurs de tension de la batterie (U) sous forme de courbes de l'hystérésis pendant une sollicitation et par l'évaluation ultérieure des courbes de l'hystérésis enregistrées, pour déterminer la grandeur caractéristique (H) pour la quantité de charge (Q) encore prélevable (Q).

**9.** Procédé selon l'une des revendications précédentes,
**caractérisé par**
l'interpolation et/ou l'extrapolation de valeurs de tension de la batterie (U) et de valeurs de courant de la batterie (I) pour déterminer les tensions de la batterie (U) à des courants de la batterie (I) prédéterminés ou pour déterminer les courants de la batterie (I) à des tensions de la batterie (U) prédéterminées.

**10.** Procédé selon l'une des revendications précédentes,
**caractérisé par**
la détermination de l'état de charge (SOC) de la batterie d'accumulateur et/ou de la température de la batterie (TBat) et par la correction de la grandeur caractéristique (H) par l'état de charge (SOC) et/ou la température de la batterie (TBat).

**11.** Procédé selon l'une des revendications précédentes,
**caractérisé par**
la correction de la grandeur caractéristique (H) par la capacité de charge prélevée pendant une durée définie.

**12.** Procédé selon l'une des revendications précédentes,
**caractérisé en ce que**
la détermination de la grandeur caractéristique (H) a lieu lorsque la durée entre les instants (t) des valeurs de tension de la batterie (U) ou des valeurs de courant de la batterie (I) mises en relation est supérieure à une durée minimale définie et est inférieure à une durée maximale définie.

**13.** Procédé selon l'une des revendications précédentes,
**caractérisé par**
la comparaison de la grandeur caractéristique (H) avec des champs caractéristiques prédéterminés pour les quantités de charge (Q) prélevables, en fonction des états de charge (SOC), des températures de la batterie (TBat) et des grandeurs caractéristiques (H).

**14.** Procédé selon la revendication 13,

**caractérisé par**

la saisie et l'enregistrement de champs caractéristiques (HLern) pour grandeurs caractéristiques (H) d'une batterie d'accumulateur à l'état neuf en fonction de l'état de charge (SOC) et des températures de la batterie (TBat) ainsi que par la détermination de la quantité de charge prélevable (Q) à partir de la grandeur caractéristique (H) déterminée, pendant un état de charge instantané ($SOC_m$) et une température instantanée de la batterie ($TBat_m$), avec une grandeur caractéristique de valeur nominale ($H_{neu}$) correspondante, qui est déterminée à partir du champs caractéristique (HLern) pour l'état de charge instantané ($SOC_m$) et la température instantanée de la batterie ($TBat_m$).

15. Procédé selon la revendication 14,

**caractérisé par**

le calcul d'un chiffre d'indice (J) en tant que différence ou rapport entre la grandeur caractéristique déterminée ($H_m$) et la grandeur caractéristique ($H_{neu}$) correspondante à l'état neuf pendant l'état de charge instantané ($SOC_m$) et la température instantanée de la batterie ($TBat_m$), ainsi que par la détermination de la quantité de charge prélevable (Q) avec un champ caractéristique des valeurs de quantités de charge prélevables (Q) enregistrées en fonction des états de charge (SOC), de la température de la batterie (TBat) et du nombres de mesures (J) dans le champ caractéristique.

16. Procédé selon l'une des revendications précédentes,

**caractérisé par**

la détermination de la grandeur caractéristique (H) à partir de paramètres d'un schéma de câblage de remplacement ou d'un modèle, les paramètres étant déterminés par adaptation du schéma de câblage de remplacement ou du modèle aux valeurs de courant de la batterie (I) et/ou aux valeurs de tension de la batterie (U) déterminées durant la phase d'élévation et de diminution.

17. Dispositif de surveillance d'une batterie d'accumulateur comportant des moyens de mesure pour mesurer des valeurs de tension de la batterie (U) et des valeurs de courant de la batterie (I) et comportant des moyens d'exploitation,

**caractérisé en ce que**

les moyens d'exploitation sont configurés pour réaliser le procédé selon l'une des revendications précédentes.

Fig. 1

Fig. 2

**Verfügbare Ladungsmenge Q bezogen auf den Neuzustand [%]**

Fig. 3

**Verfügbare Ladungsmenge Q bezogen auf den Neuzustand [%]**

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19950424 A1
- DE 3712629 C2
- WO 9917128 A
- DE 3901680 C2
- DE 19847648 A1
- WO 0004620 A
- DE 10049495 A1
- EP 1167987 A1